**Europäisches Patentamt**

**European Patent Office**

**Office européen des brevets**

(11) Veröffentlichungsnummer: **0 014 387**
**B1**

(12) **EUROPÄISCHE PATENTSCHRIFT**

(45) Veröffentlichungstag der Patentschrift:
23.02.83

(21) Anmeldenummer: 80100356.7

(22) Anmeldetag: 23.01.80

(51) Int. Cl.³: **H 03 B 5/36,** H 03 C 3/22,
H 03 K 3/283

(54) Frequenzsteuerbarer Quarzoszillator mit grossem Ziehbereich.

(30) Priorität: 02.02.79 DE 2904045

(43) Veröffentlichungstag der Anmeldung:
20.08.80 Patentblatt 80/17

(45) Bekanntmachung des Hinweises auf die Patenterteilung:
23.02.83 Patentblatt 83/8

(84) Benannte Vertragsstaaten:
AT BE CH DE FR GB IT LU NL SE

(56) Entgegenhaltungen:
**keine**

(73) Patentinhaber: SIEMENS AKTIENGESELLSCHAFT,
Berlin und München Wittelsbacherplatz 2,
D-8000 München 2 (DE)

(72) Erfinder: Kahn, Klaus-Dieter, Dipl.-Ing.,
Klobensteinerstrasse 32, D-8000 München 90 (DE)
Erfinder: Thanhäuser, Gerhard, Dipl.-Ing.,
Mozartstrasse 9, D-8905 Mering (DE)

Frequenzsteuerbarer Quarzoszillator mit grossem Ziehbereich

Die Erfindung betrifft einen frequenzsteuerbaren Quarzoszillator mit kombiniertem kapazitivinduktivem Ziehen, mit einer ersten Reihenschaltung, die eine Varaktordiode, eine erste Induktivität und einen Quarz enthält, zu der eine zweite Reihenschaltung aus zwei Kondensatoren, von denen ein erster durch einen ersten Widerstand überbrückt ist, parallelgeschaltet ist, dass an den einen Verbindungspunkt der beiden Reihenschaltungen der Basisanschluss eines ersten Transistors angeschlossen ist, dessen Emitteranschluss über einen fünften Widerstand mit einem ersten Betriebsspannungsanschluss direkt und ausserdem mit dem Verbindungspunkt der beiden Kondensatoren über eine Rückkopplung verbunden ist, dass der andere Verbndungspunkt der beiden Reihenschaltungen an einen zweiten Betriebsspannungsanschluss angeschlossen ist, dass der Kollektoranschluss des ersten Transistors mit einem Ausgangsanschluss und über einen vierten Widerstand mit dem zweiten Betriebsspannungsanschluss verbunden ist und dass an der Varaktordiode eine Steuerspannung anliegt.

Ein frequenzsteuerbarer Quarzoszillator mit grossem Ziehbereich ist bereits in der älteren Patentanmeldung P 28 18 374.6 (VPA 78 P 6602) beschrieben. Weiterhin sind derartige Quarzoszillatoren aus der «Funkschau», 1971, Heft 15, S. 465 und 466 bekannt, wobei dort zur Erzielung höherer Frequenzen Obertonquarze verwendet werden. Zur Frequenzsteuerung derartiger Quarzoszillatoren werden in der Regel Varaktordioden verwendet, deren Kapazität in Abhängigkeit von der angelegten Spannung veränderbar ist. Die Varaktordiode ist zu diesem Zweck in Reihe mit dem zu ziehenden Quarz geschaltet, wobei auf die Beibehaltung eines Gleichstromweges zu achten ist. Im Hinblick auf die Verwendung von derartigen Oszillatoren in Phasenregelschleifen wird neben einer guten Frequenzziehbarkeit insbesondere gewünscht, dass die von diesen Oszillatoren abgegebene Schwingung nur eine sehr geringe Amplitudenmodulation bei Wechselspannunsaussteuerung der Varaktordiode aufweist. Voraussetzung dafür ist eine gute symmetrische Begrenzerwirkung in diesen Oszillatoren.

Aus der DE-A-2 420 420, insbesondere deren Fig. 1, 3 und 4 mit zugehöriger Beschreibung, ist ein frequenzsteuerbarer Quarzoszillator zur Verwendung in einer Modulationsschaltung mit geringen Verzerrungen bekannt, wie sie beispielsweise in Funksprechgeräten im UHF- bzw. VHF-Band bei direkter Modulation im Oberton Verwendung findet. Es wird deshalb ein Obertonquarz verwendet und aus dem vom Transistor abgegebenen Signalgemisch wird die dritte Oberwelle ausgefiltert. Die Signalausbeute bei der dritten Oberwelle ist dabei vom Stromflusswinkel des Kollektorstroms des Transistors abhängig und damit in gewissen Grenzen von der Spannung an der Varaktordiode. Durch eine Veränderung des Momentanwertes der Sperrspannung an der Varaktordiode ändern sich entsprechend der resultierende Quarz-Verlustwiderstand und die Umlaufverstärkung und damit der Stromflusswinkel des Transistors und die Begrenzungseigenschaften. Die Änderung des Stromflusswinkels des Transistor-Kollektorstromes geht aber direkt in die Amplitude bei der dritten Oberwelle ein. Damit erzeugt aber eine Wechselspannung an der Varaktordiode zwangsläufig eine Amplitudenmodulation bei der dritten Oberwelle, so dass sich bei einem derartigen Quarzoszillator keine symmetrische und definierte Begrenzung ergeben kann. Die Aufgabe der Erfindung besteht also darin, eine Schaltung der eingangs erwähnten Art so weiterzuentwickeln, dass eine exakte symmetrische Begrenzung der erzeugten Schwingung erreicht wird.

Erfindungsgemäss wird die Aufgabe dadurch gelöst, dass als Quarz ein Grundtonquarz vorgesehen ist, dass die erste Reihenschaltung einen zwischen Quarz und transistorseitigem Verbindungspunkt beider Reihenschaltungen eingeschalteten dritten Widerstand enthält, dass der Emitteranschluss des ersten Transistors über eine Diode an den Verbindungspunkt der beiden Kondensatoren angeschlossen ist, dass der zweite Kondensator durch einen zweiten Widerstand überbrückt ist, dass der eine Anschluss der Varaktordiode den mit der zweiten Bezugsspannungsquelle verbundenen Anschluss der ersten Reihenschaltung darstellt und dass der andere Anschluss der Varaktordiode über die erste Induktivität mit dem Quarz und mit einem sechsten Widerstand zur Steuerspannungszuführung verbunden ist.

Zweckmässige Ausgestaltungen des erfindungsgemässen Quarzoszillators sind den Patentansprüchen 2 bis 7 zu entnehmen.

Grundtonquarze für den ins Auge gefassten Frequenzbereich oberhalb von 25 MHz sind aus technologischen Gründen nur schwer herstellbar. Es kann deshalb zweckmässig sein, die Verwendung eines Grundtonquarzes mit der Verwendung eines Frequenzverdopplers, der dann ebenfalls gute symmetrische Begrenzungseigenschaften aufweisen muss, zu koppeln. Derartige Weiterbildungen der Erfindung sind in den Patentansprüchen 6 und 7 beschrieben.

Die Erfindung soll im folgenden anhand der Zeichnung näher erläutert werden.

In der Zeichnung zeigt

Fig. 1 die Schaltung einer Schwingstufe und

Fig. 2 die Schaltung der Schwingstufe mit nachgeschaltetem Frequenzverdoppler.

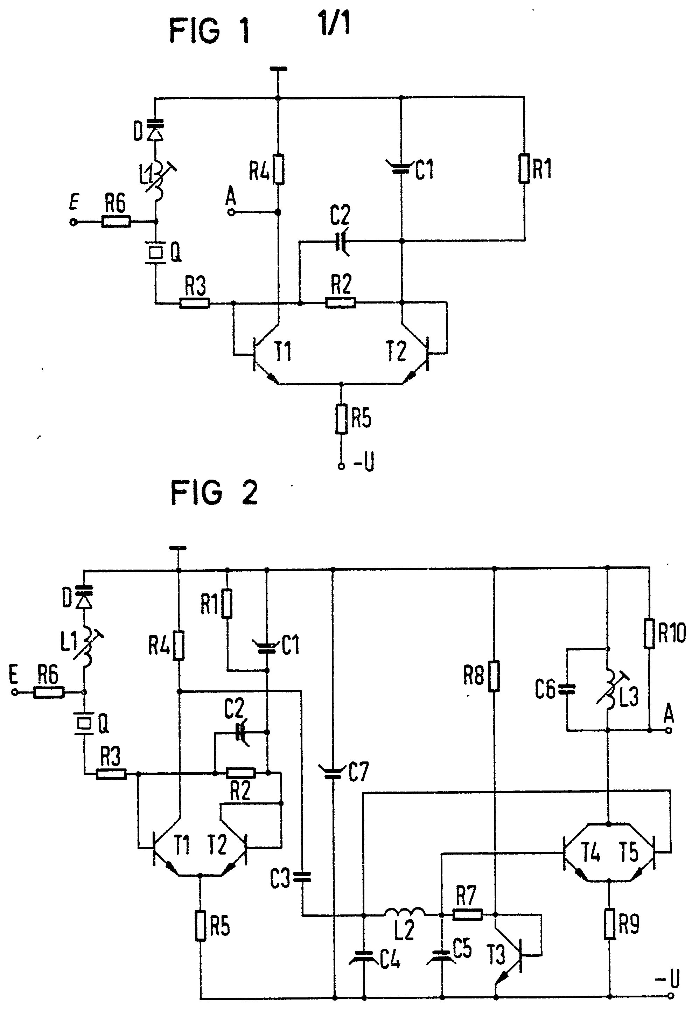

In der Fig. 1 wird der Resonanzkreis durch die Varaktordiode D, die einstellbare Induktivität L1, dem Quarz Q, dem Dämpfungswiderstand R3 und den beiden Kondensatoren C1, C2 in der Art einer Dreipunktschaltung gebildet. Mit dem Resonanzkreis ist eine Stromspiegelschaltung aus den beiden npn-Transistoren T1 und T2 verbunden. Der Transistor T2 ist dabei in bekannter Weise als Diode geschaltet, dadurch steuert die am Kondensator C2 auftretende Schwingspannung über dessen Emitteranschluss den Transistor T1. Im Kleinsignalbetrieb wird dabei durch die zur Emitterdiode des Transistors T1 entgegengesetzt gepolte Emitterdiode des Transistors T2 die Steilheit des Transistors T1 halbiert. Unmittelbar nach dem Einschalten, also vor dem Anschwingen des Quarzes, fliesst der durch den fünften Widerstand R5 eingeprägte Strom zunächst zu gleichen Teilen durch die Transistoren T1 und T2. Im eingeschwungenen Betrieb ist die Wechselspannungsamplitude am zweiten Kondensator C2 erheblich grösser als der Aussteuerungsbereich der durch die beiden Transistoren gebildeten Antiserienschaltung. Dadurch werden beide Transistoren annähernd rechteckförmig und symmetrisch umgeschaltet. Die symmetrische Begrenzungseigenschaft äussert sich dabei im Fehlen von amplitudenmodulierten Seitenbändern im erzeugten Signal beim Betrieb des Oszillators mit Wechselspannung an der Kapazitätsdiode, also bei einer Frequenzmodulation. Dies ist bei der Verwendung in Phasenregelschleifen im Hinblick auf die hohen zu verarbeitenden Frequenzhübe zu beachten. Das erzeugte Signal kann an dem mit dem Kollektoranschluss des ersten Transistors T1 verbundenen Ausgangsanschluss abgenommen werden. Die Amplitude des Quarzstromes und damit die Amplitude des Ausgangssignals wird dabei durch den Kapazitätswert der beiden Kondensatoren und durch den Widerstandswert des gemeinsamen Emitterwiderstandes R5 beeinflusst. Die Amplitude des Quarzstromes wird weiterhin durch den Dämpfungswiderstand R3 mitbestimmt. Dieser Widerstand entspricht etwa dem in der Schaltung maximal möglichen Quarzresonanzwiderstand. Damit kann verhindert werden, dass bei Quarzen sehr hoher Güte und entsprechend sehr kleinem Quarzresonanzwiderstand die Kapazitätsdiode übersteuert wird.

Im Hinblick auf die leichte Ziehbarkeit wurde im vorliegenden Ausführungsbeispiel als Quarz ein Grundtonquarz gewählt. Um dennoch eine Schwingung mit einer Frequenz von etwa 26 MHz erzeugen zu können, wurde ein Frequenzverdoppler nachgeschaltet, der die an den Oszillator gestellten Anforderungen hinsichtlich des Wegfalls von amplitudenmodulierten Seitenbändern und hinsichtlich des geringen Stromverbrauchs erfüllt. Die dadurch entstandene Anordnung ist in der Fig. 2 dargestellt. Die in der Fig. 2 enthaltene Schwingschaltung entspricht der nach der Fig. 1, vom Kollektoranschluss des ersten Transistors dieser Schwingschaltung wird über einen dritten Kondensator C3 die symmetrisch begrenzte rechteckförmige Ausgangsspannung abgenommen und einem auf die Schwingfrequenz abgestimmten zweiten Schwingkreis zugeführt. Der zweite Schwingkreis enthält eine zweite Induktivität L2, deren einer Anschluss mit dem dritten Kondensator C3 verbunden ist, und deren anderer Anschluss an den siebenten Widerstand R7 angeschlossen ist. Ausserdem sind beide Anschlüsse über gleich grosse Kondensatoren C4, C5 mit Masse verbunden. An den beiden Anschlüssen der Induktivität werden zwei zueinander um 180° gedrehte Spannungen entnommen, die jeweils getrennt den beiden Steuereingängen eines emittergekoppelten Differenzverstärkers zugeführt werden, der durch den vierten und den fünften npn-Transistors T4, T5 und den gemeinsamen Emitterwiderstand R9 gebildet ist. Die Vorspannungserzeugung für diesen Differenzverstärker erfolgt mittels eines Spannungsteilers aus dem achten Widerstand R8 und dem als Diode geschalteten dritten npn-Transistor T3, der Mittelanschluss dieses Spannungsteilers ist an den anderen Anschluss des siebenten Widerstandes R7 geführt. Da die beiden Kollektoranschlüsse des vierten und des fünften Transistors des emittergekoppeltern Differenzverstärkers miteinander verbunden sind, ergibt sich am Verbindungspunkt eine Schwingung mit der gegenüber der Ausgangsfrequenz doppelten Frequenz, die vom Verbindungspunkt der beiden Kollektoranschlüsse einem dritten, auf diese Frequenz abgestimmten Schwingkreis zugeführt wird. Dieser Schwingkreis besteht aus dem sechsten Kondensator C6 und der dritten Induktivität L3, ausserdem ist dieser Parallelschwingkreis durch den parallelgeschalteten zehnten Widerstand R10 bedämpft. Am Verbindungspunkt des dritten Schwingkreises mit dem Differenzverstärker ist der Ausgangsanschluss A der Anordnung angeschaltet.

1. Frequenzsteuerbarer Quarzoszillator in Dreipunktschaltung mit kombiniertem Kapazitiv-induktivem Ziehen, mit einer ersten Reihenschaltung, die eine Varakordiode (D), eine erste Induktivität (L1) und einen Quarz (Q) enthält, zu der eine zweite Reihenschaltung aus zwei Kondensatoren (C1, C2), von denen ein erster durch einen ersten Widerstand (R1) überbrückt ist, parallelgeschaltet ist, dass an den einen Verbindungspunkt der beiden Reihenschaltungen der Basisanschluss eines ersten Transistors (T1) angeschlossen ist, dessen Emitteranschluss über einen fünften Widerstand (R5) mit einem ersten Betriebsspannungsanschluss (−U) direkt und ausserdem mit dem Verbindungspunkt der beiden Kondensatoren (C1, C2, über eine Rückkoppelung verbunden ist, dass der andere Verbindungspunkt der beiden Reihenschaltungen an einen zweiten Betriebsspannungsanschluss angeschlossen ist, dass der Kollektoranschluss des ersten Transistors (T1) mit einem Ausgangsanschluss (A) und über einen vierten Widerstand (R4) mit dem zweiten Betriebsspannungsanschluss verbunden ist und dass an der Varaktordiode (D) eine Steuerspannung anliegt, dadurch gekennzeichnet, dass als Quarz (Q) ein Grundtonquarz vorgesehen ist, dass die erste Reihenschaltung einen zwischen Quarz (Q) und transistorseitigem Verbindungspunkt beider Reihenschaltungen eingeschalteten dritten Widerstand (R3) enthält, dass der Emitteranschluss des ersten Transistors (T1) über eine Diode (T2) an den Verbindungspunkt der beiden Kondensatoren (C1, C2) angeschlossen ist, dass der zweite Kondensator (C2) durch einen zweiten Widerstand (R2) überbrückt ist, dass der eine Anschluss der Varaktordiode (D) den mit der zweiten Bezugsspannungsquelle verbundenen Anschluss der ersten Reihenschaltung darstellt und dass der andere Anschluss der Varaktordiode (D) über die erste Induktivität (L1) mit dem Quarz (Q) und mit einem sechsten Widerstand (R6) zur Steuerspannungszuführung (E) verbunden ist.

2. Frequenzsteuerbarer Quarzoszillator nach Patentanspruch 1, dadurch gekennzeichnet, dass als erster Transistor (T1) und als Diode (T2) jeweils ein npn-Transistor vorgesehen ist, dass diese Transistoren nach Art einer Stromspiegelschaltung miteinander verbunden sind und dass an den ersten Betriebsspannungsanschluss die negative (–U) und an den zweiten Betriebsspannungsanschluss die positive (Masse) Betriebsspannung angeschlossen sind.

3. Frequenzsteuerbarer Quarzoszillator nach Patentanspruch 2, dadurch gekennzeichnet, dass es sich bei den Transistoren (T1, T2) um gepaarte Einzeltransistoren handelt.

4. Frequenzsteuerbarer Quarzoszillator nach Patentanspruch 2, dadurch gekennzeichnet, dass die beiden Transistoren (T1/T2) in einem monolithischen Transistorarray enthalten sind.

5. Frequenzsteuerbarer Quarzoszillator nach Patentanspruch 1, dadurch gekennzeichnet, dass der Wert des Dämpfungswiderstandes (R3) etwa dem in der Schaltung maximal möglichen Resonanzwiderstand des Quarzes (Q) entspricht.

6. Frequenzsteuerbarer Quarzoszillator nach Patentanspruch 1, dadurch gekennzeichnet, dass an den Kollektoranschluss des ersten Transistors (T1) ein auf die Schwingfrequenz abgestimmter LC-Schwingkreis (L2, C3, C4, C5) angeschlossen ist, dem zwei zueinander um 180° gedrehte Spannungen entnommen und jeweils getrennt den beiden Steuereingängen eines emittergekoppelten Differenzverstärkers (T4, T5) zugeführte werden und dass die beiden Ausgangsanschlüsse des Differenzverstärkers miteinander verbunden sind und an einem auf die doppelte Schwingfrequenz abgestimmten LC-Schwingkreis (C3, C6) am Signalausgang (A) die doppelte Schwingfrequenz des Quarzes (Q) abgeben.

7. Frequenzsteuerbarer Quarzoszillator nach Patentanspruch 6, dadurchgekennzeichnet, dass der auf die Schwingfrequenz abgestimmte LC-Schwingkreis eine zweite Induktivität (L2) enthält, deren erster Anschluss über einen dritten Kondensator (C3) dem Kollektoranschluss des ersten Transistors, mit dem einen Steuereingang des emittergekoppelten Differenzverstärkers und über einen vierten Kondensator (C4) mit Masse verbunden ist, dass der zweite Anschluss der Induktivität über einen fünften Kondensator (C5) mit Masse, mit dem anderen Steuereingang des emittergekoppelten Differenzverstärkers (T4, T5) und über einen siebenten Widerstand (R7) mit einer Vorspannungsquelle verbunden ist, die durch einen Widerstand (R8) in Reihe zu einem als Diode geschalteten Transistor (T3) gebildet ist.

**Revendications**

1. Oscillateur piézo-électrique à fréquence susceptible d'être commandée et en montage à trois points avec traînage de fréquence capacitif/inductif combiné, du type comportant un premier circuit série pourvu d'un varactor (D), d'une première inductance (L1) et d'un quartz (Q) et sur lequel est monté en parallèle un second circuit série constitué par deux condensateurs (C1, C2) parmi lesquels un premier est shunté par une première résistance (R1), qu'à l'un des points de liaison des deux circuits série est reliée une borne de base d'un premier transistor (T1) dont la borne d'émetteur est reliée par l'intermédiaire d'une cinquième résistance (R5) directement à une première borne de tension de fonctionnement (–U) et en outre, par l'intermédiare d'une contre-réaction, au point de liaison des deux condensateurs (C1, C2), que l'autre point de liaison des deux circuits série est relié à une seconde borne de tension de fonctionnement, que la borne de collecteur du premier transistor (T1) est reliée à une borne de sortie (A) et, par l'intermédiaire d'une quatrième résistance (R4), à la seconde borne de tension de service et qu'au varactor (D) est appliquée une tension de commande, caractérisé par le fait que l'on prévoit comme quartz (Q) un cristal fondamental, que le premier circuit série comporte une troisième résistance (R3) montée entre le quartz (Q) et le point de liaison des deux circuits série qui est situé du côté du transistor, que la borne d'émetteur du premier transistor (T1) est reliée, par l'intermédiaire d'une diode (T2) au point de liaison des deux condensateurs (C1, C2), que le second condensateur (C2) est shunté par une seconde résistance (R2), que l'une des bornes du varactor (D) représente la borne du premier circuit série, qui est reliée à la seconde source de tension de référence, et que l'autre borne du varactor (D) est reliée par l'intermédiaire de la première inductance (L1) au quartz (Q) et à une sixième résistance (R6) pour l'application de la tension de commande (E).

2. Oscillateur piézo-électrique à fréqunce susceptible d'être commandée, selon la revendication 1, caractérisé par le fait que l'on prévoit comme premier transistor (T1) et comme diode (T2) respectivement un transistor npn, que ces transistors sont reliés entre eux à la manière d'un montage à courants en rapport géométrique, et qu'à la première borne de tension de fonctionnement est appliquée la tension de fonctionnement négative (–U) et à la seconde borne de tension de fonctionnement, la tension de fonctionnement positive (masse).

3. Oscillateur piézo-électrique à fréquence susceptible d'être commandée, selon la revendication 2, caractérisé par le fait que dans le cas des transistors (T1, T2) il s'agit de transistors individuels appariés.

4. Oscillateur piézo-électrique à fréquence susceptible d'être commandée, selon la revendication 2, caractérisé par le fait que les deux transistors (T1/T2) sont contenus dans une rangée monolithique de transistors.

5. Oscillateur piézo-électrique à fréquence susceptible d'être commandée, selon la revendication 1, caractérisé par le fait que la valeur de la résistance d'atténuatioń (R3) correspond sensiblement à la résistance de résonance du quartz (Q) maximale possible dans le circuit.

6. Oscillateur piézo-électrique à fréquence susceptible d'être commandée, selon la revendication 1, caractérisé par le fait qu'à la borne de connecteur du premier transistor (T1) est relié un circuit oscillant LC (L2, C3, C4, C5) accordé à la fréquence d'oscillation, circuit oscillant sur lequel on prélève deux tensions déphasées entre elles de 180° et appliquées respectivement et séparément aux deux entrées de commande d'un amplificateur différentiel (T4, T5) à couplage d'émetteur, et que les deux bornes de sortie des amplificateurs différentiels sont reliées entre elles et fournissent au niveau de la sortie des signaux (A) d'un circuit oscillant LC (C3, C6) accordé à la double fréquence d'oscillation, la double fréquence d'oscillation du quartz (Q).

7. Oscillateur piézo-électrique à fréquence susceptible d'être commandée, selon la revendication 6, caractérisé par le fait que le circuit oscillant LC qui est accordé à la fréquence d'oscillation, comporte une seconde inductance (L2) dont la première borne est reliée par l'intermédiaire d'un troisième condensateur (C3), à la borne de collecteur du premier transistor, à l'une des entrées de commande de l'amplificateur différentiel à couplage d'émetteur, et, par l'intermédiaire d'un quatrième condensateur (C4), à la masse, que la seconde borne de l'inductance est reliée par l'intermédiaire d'un conquième condensateur (C5), à la masse, à l'autre entrée de commande de l'amplificateur différentiel à couplage d'émetteur (T4, T5), et, par l'intermédiaire d'une septième résistance (R7), à une source de tension de polarisation qui est formée par la résistance (R8) en série avec un transistor (T3) monté en diode.

**Claims**

1. A frequency-controllable quartz crystal oscillator in the form of a three-terminal network utilising combined capacitive-inductive pulling, comprising a first series circuit combination of a varactor diode (D), a first inductance (L1), and a quartz crystal (Q), which combination is connected in parallel with a second series circuit combination consisting of two capacitors (C1, C2) a first one of which is bridget by a first resistor (R1), a first connection point of the two series circuit combinations being connected to the base electrode of a first transistor (T1) whose emitter electrode is directly connected via a fifth resistor (R5) to a first operating voltage supply terminal (–U) and to the junction of the two capacitors (C1, C2) via a feedback arrangement, the other connection point of the two series circuit combinations being connected to a second operating voltage supply terminal, the collector electrode of the first transistor (T1) being connected to an output terminal (A) and via a fourth resistor (R4) to the second operating voltage supply terminal, and the varactor diode (D) being connected to a control voltage, characterised in that, the quartz crystal (Q) consists of a fundamental crystal, that the first series circuit combination contains a third resistor (R3) connected between the quartz crystal (Q) and the transistor-end connection point of the two series circuit combinations, that the emitter electrode of the first transistor (T1) is connected via a diode (T2) to the junction point of the two capacitors (C1, C2), that the second capacitor (C2) is bridged by a second resistor (R2), that the first terminal of the varactor diode (D) is the terminal of the first series circuit combination connected to the second reference voltage supply source, and that the other terminal of the varactor diode (D) is connected via the first inductance (L1) to the quartz crystal (Q) via a sixth resistor (R6) to the control voltage supply (E).

2. A frequency controllable quartz crystal oscillator as claimed in Claim 1, characterised in that a npn-transistor is provided for both the first transistor (T1) and the diode (T2), that these transistors are connected to one another in the manner of a current reflector circuit, and that the negative (–U) operating voltage is connected to the first operating voltage supply terminal whereas the positive (earth) operating voltage is connected to the second operating voltage terminal.

3. A frequency controllable quartz crystal oscillator as claimed in Claim 2, characterised in that the transistors (T1, T2) consist of matched individual transistors.

4. A frequency controllable quartz crystal oscillator as claimed in Claim 2, characterised in that the two transistors (T1/T2) are contained in a monolithic transistor array.

5. A frequency controllable quartz crystal oscillator as claimed in Claim 1, characterised in that the value of the attenuation resistor (R3) corresponds approximately to the maximum possible resonance resistance of the quartz crystal (Q) within the circuit.

6. A frequency controllable quartz crystal oscillator as claimed in Claim 1, characterised in that the collector electrode of the first transistor (T1) is connected to a LC-oscillating circuit (L2, C2, C4, C5) which is tuned ot the oscillating frequency and from which are withdrawn two voltages rotated by 180° relative to one another, and separately conducted to the two control inputs of an emitter-coupled differential amplifier (T4, T5), and that the two output terminals of the differential amplifier are connected to one another and in an LC-oscillatory circuit (C3, C6) tuned to double the oscillating frequency and emit double the oscillating frequency of the quartz crystal (Q) from the signal output (A).

7. A frequency controllable quartz crystal oscillator as claimed in Claim 6, characterised in that the LC-oscillatory circuit which is tuned to the oscillating frequency contains a second inductance (L2) whose first terminal is connected via a third capacitor (C3) to the collector electrode of the first transistor, to the first control input of the emitter coupled differential amplifier, and via a fourth capacitor (C4) to earth, that the second terminal of the inductance is connected via a fifth capacitor (C5) to earth, to the other control input of the emitter-coupled differential amplifier (T4, T5) and via a seventh resistor (R7) to a bias voltage source which is formed by a resistor (R8) in series with a transistor (T3) connected as a diode.

# FIG 1  1/1

# FIG 2